# EUROPÄISCHE PATENTSCHRIFT

(11) **EP 2 865 001 B1**
(45) Veröffentlichungstag und Bekanntmachung des Hinweises auf die Patenterteilung: **05.08.2020**
(21) Anmeldenummer: 13730244.4
(22) Anmeldetag: 19.06.2013
(51) Int. Cl.: H01L 21/36, H01L 31/032, H01L 31/0749

(54) **SCHICHTSYSTEM FÜR DÜNNSCHICHTSOLARZELLEN**
LAYER SYSTEM FOR THIN FILM SOLAR CELLS
SYSTÈME À COUCHES POUR CELLULES SOLAIRES À COUCHE MINCE

(30) Priorität: 20.06.2012 EP 12172700
(43) Veröffentlichungstag der Anmeldung: 29.04.2015
(73) Patentinhaber: (CNBM) Bengbu Design & Research Institute for Glass Industry Co., Ltd., Bengbu (CN)
(72) Erfinder: PALM, Jörg, 80797 München (DE); POHLNER, Stephan, 81541 München (DE); HAPP, Thomas, 81825 München (DE); DALIBOR, Thomas, 82211 Herrsching am Ammersee (DE); DIETMÜLLER, Roland, 80636 München (DE)
(74) Vertreter: Gebauer, Dieter Edmund
(86) Internationale Anmeldenummer: PCT/EP2013/062726
(87) Internationale Veröffentlichungsnummer: WO 2013/189976

(56) Entgegenhaltungen:
- EP-A2- 2 367 208
- US-A1- 2011 048 522
- HASHIMOTO Y ET AL: "(Zn,In)Sx alloy buffer for CuInS2 solar cells", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 11. Mai 2003 (2003-05-11), Seiten 535-538Vol.1, XP031987626, ISBN: 978-4-9901816-0-4
- LAZZEZ S ET AL: "A Boubaker polynomials expansion scheme (BPES)-related protocol for measuring sprayed thin films thermal characteristics", CURRENT APPLIED PHYSICS, NORTH-HOLLAND, AMSTERDAM, NL, Bd. 9, Nr. 5, 9. Januar 2009 (2009-01-09), Seiten 1129-1133, XP026120982, ISSN: 1567-1739, DOI: 10.1016/J.CAP.2008.12.010 [gefunden am 2009-01-09]
- LI M ET AL: "Preparation and characterization of ZnIn2S4 thin films deposited by spray pyrolysis for hydrogen production", INTERNATIONAL JOURNAL OF HYDROGEN ENERGY, ELSEVIER SCIENCE PUBLISHERS B.V., BARKING, GB, Bd. 33, Nr. 12, 27. Mai 2008 (2008-05-27), Seiten 2891-2896, XP022713365, ISSN: 0360-3199, DOI: 10.1016/J.IJHYDENE.2008.04.008 [gefunden am 2008-05-27]

## Beschreibung

Die vorliegende Erfindung betrifft ein Schichtsystem für Dünnschichtsolarzellen und ein Verfahren zur Herstellung des Schichtsystems.

Dünnschichtsysteme für Solarzellen und Solarmodule sind hinreichend bekannt und in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Aufgrund der physikalischen Eigenschaften und der technologischen Handhabbarkeit sind Dünnschichtsysteme mit amorphen, mikromorphen oder polykristallinen Silizium, Cadmium-Tellurid (CdTe), Gallium-Arsenid (GaAs), Kupfer-Indium-(Gallium)-Selenid-Sulfid (Cu(In,Ga)(S,Se)₂), Kupfer-Zink-Zinn-Sulfo-Selenid (CZTS aus der Gruppe der Kesterite) sowie organischen Halbleitern besonders für Solarzellen geeignet. Der pentenäre Halbleiter Cu(In,Ga)(S,Se)₂ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Aktuelle Dünnschichtsolarzellen und Solarmodule auf Basis von Cu(In,Ga)(S,Se)₂ benötigen eine Pufferschicht zwischen p-leitendem Cu(In,Ga)(S,Se)₂-Absorber und n-leitender Frontelektrode, die üblicherweise Zinkoxid (ZnO) umfasst. Nach derzeitiger Erkenntnis ermöglicht diese Pufferschicht eine elektronische Anpassung zwischen Absorbermaterial und Frontelektrode. Sie bietet außerdem einen Schutz vor Sputterschäden im nachfolgenden Prozessschritt der Abscheidung der Frontelektrode durch DC-Magnetron-Sputtern. Zusätzlich verhindert sie durch Aufbau einer hochohmigen Zwischenschicht zwischen p- und n-Halbleiter den Stromabfluss von elektronisch guten in schlechte Bereiche.

Bisher wurde am häufigsten Kadmiumsulfid (CdS) als Pufferschicht verwendet. Um gute Wirkungsgrade der Zelle erzeugen zu können, wurde CdS bisher in einem chemischen Badprozess (CBD-Prozess) nasschemisch abgeschieden. Damit ist allerdings der Nachteil verbunden, dass der nasschemische Prozess nicht gut in den Prozessablauf der gegenwärtigen Produktion von Cu(In,Ga)(S,Se)₂-Dünnschichtsolarzellen passt.

Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess getroffen werden müssen, beispielsweise bei der Entsorgung des Abwassers. Des Weiteren entstehen bei der Entsorgung des Produktes nach Ablauf der Lebenszeit der Solarzelle weitere Kosten.

Es wurden daher verschiedene Alternativen zum Puffer aus CdS für unterschiedliche Absorber aus der Familie der Cu(In,Ga)(S,Se)₂-Halbleiter getestet; beispielsweise gesputtertes ZnMgO, durch CBD abgeschiedenes Zn(S,OH), durch CBD abgeschiedenes In(O,OH) und Indiumsulfid, abgeschieden durch ALD (AtomicLayer Deposition), ILGAR (Ion Layer Gas Deposition), Spray Pyrolyse oder PVD (Physical Vapor Deposition)-Verfahren, wie thermisches Verdampfen oder Sputtern.

Allerdings eignen sich diese Materialien noch nicht als Puffer für Solarzellen auf Basis von Cu(In,Ga)(S,Se)₂ für eine kommerzielle Nutzung, da sie nicht die gleichen Wirkungsgrade (Verhältnis von eingestrahlter Leistung zur erzeugten elektrischen Leistung einer Solarzelle) erreichen, wie solche mit einer CdS-Pufferschicht. Die Wirkungsgrade für solche Module liegen bei etwa bis nahezu 20 % für Laborzellen auf kleinen Flächen sowie zwischen 10% und 12% für großflächige Module. Weiterhin zeigen sie zu große Instabilitäten, Hystereseeffekte oder Degradationen im Wirkungsgrad, wenn sie Licht, Wärme und/oder Feuchte ausgesetzt sind.

Ein weiterer Nachteil von CdS liegt darin begründet, dass CdS ein direkter Halbleiter mit einer direkten elektronischen Bandlücke von etwa 2.4 eV ist. Daher wird in einer Cu(In,Ga)(S,Se)₂/CdS/ZnO-Solarzelle schon bei CdS-Schichtdicken von einigen 10 nm das einfallende Licht großteilig absorbiert. Das in der Pufferschicht absorbierte Licht geht für die elektrische Ausbeute verloren, da die erzeugten Ladungsträger in dieser Schicht gleich wieder rekombinieren, da es in diesem Bereich des Heteroübergangs und im Puffermaterial viele als Rekombinationszentren wirkende Kristalldefekte gibt. Damit geht das in der Pufferschicht absorbierte Licht für die elektrische Ausbeute verloren. Als Folge wird der Wirkungsgrad der Solarzelle kleiner, was für eine Dünnschichtzelle nachteilig ist.

Ein Schichtsystem mit einer Pufferschicht auf Basis von Indiumsulfid ist beispielsweise aus WO2009141132 A2 bekannt. Das Schichtsystem besteht aus einem Chalcopyrit-Absorber der CIS-Familie, insbesondere Cu(In,Ga)(S,Se)₂ in Verbindung mit einer Pufferschicht aus Indiumsulfid. Die Indiumsulfid(InᵥS_{w})-Pufferschicht hat beispielsweise eine leicht indiumreiche Zusammensetzung mit v/(v+w)=41% bis 43% und kann mit verschiedenen nicht-nasschemischen Verfahren abgeschieden werden, beispielsweise durch Thermisches Verdampfen, Ion Layer Gas Reaction, Kathodenzerstäubung (Sputtern), Atomic Layer Deposition (ALD) oder Sprühpyrolyse.

In der bisherigen Entwicklung dieses Schichtsystems und der Herstellungsverfahren hat sich jedoch gezeigt, dass der Wirkungsgrad von Solarzellen mit Indiumsulfid-Pufferschicht kleiner ist als der mit CdS-Pufferschichten.

Aufgabe der vorliegenden Erfindung ist es daher, ein Schichtsystem auf Basis eines Verbindungshalbleiters mit einer Pufferschicht bereitzustellen, das einen hohen Wirkungsgrad und hohe Stabilität aufweist, wobei die Herstellung kostengünstig und umweltverträglich sein soll.

Diese Aufgabe wird erfindungsgemäß durch ein Schichtsystem gemäß Anspruch 1 gelöst. Vorteilhafte Weiterbildungen der Erfindung ergeben sich aus den Unteransprüchen.

Des Weiteren umfasst die Erfindung ein Verfahren zur Herstellung eines Schichtsystems für Dünnschichtsolarzellen.

Eine Verwendung des erfindungsgemäßen Schichtsystems geht aus weiteren Ansprüchen hervor.

Das erfindungsgemäße Schichtsystem für Dünnschichtsolarzellen umfasst mindestens
- eine Absorberschicht, die einen Chalkogenidverbindungshalbleiter enthält und
- eine Pufferschicht, die auf der Absorberschicht angeordnet ist und Halogen-angereichertes ZnₓIn₁₋ₓS_{y} mit 0,01 ≤ x ≤ 0,9, 1 ≤ y ≤ 2 enthält,
wobei die Pufferschicht aus einem an die Absorberschicht angrenzenden ersten Schichtbereich mit einem Halogen-Stoffmengenanteil A₁ und einem an den ersten Schichtbereich angrenzenden zweiten Schichtbereich mit einem Halogen-Stoffinengenanteil A₂ besteht und das Verhältnis A₁/A₂ ≥ 2 beträgt.

Da die Elemente der Pufferschicht jeweils in verschiedenen Oxidationsstufen vorliegen können, werden im Folgenden alle Oxidationsstufen einheitlich mit dem Namen des Elements bezeichnet, wenn dies nicht explizit anders gekennzeichnet wird. Beispielsweise ist unter Natrium deshalb elementares Natrium, Natriumionen sowie Natrium in Verbindungen zu verstehen. Des Weiteren ist unter Halogen das elementare Halogen, Halogenid sowie Halogen in Verbindungen zu verstehen.

In einer vorteilhaften Ausgestaltung des erfindungsgemäßen Schichtsystems beträgt die Schichtdicke d₁ des ersten Schichtbereichs ≤ 50% der Schichtdicke d der gesamten Pufferschicht. Die Schichtdicke d der Pufferschicht ergibt sich aus der Summe der Schichtdicken des ersten Schichtbereichs und des zweiten Schichtbereichs. In einer bevorzugten Ausgestaltung beträgt die Schichtdicke d₁ des ersten Schichtbereichs ≤ 30 % und besonders bevorzugt ≤ 20 % der Schichtdicke d der Pufferschicht. In einer weiteren vorteilhaften Ausgestaltung der Erfindung beträgt die Schichtdicke d₁ des ersten Schichtbereichs 30 % und besonders bevorzugt 20 % der Schichtdicke d der Pufferschicht.

Die vorliegende Erfindung beruht auf der folgenden Erkenntnis der Erfinder, dass eine Anreicherung eines Halogens in der Pufferschicht an der Grenzfläche zur Absorberschicht die Leerlaufspannung und damit den Wirkungsgrad einer erfindungsgemäßen Solarzelle erhöht. Dies lässt sich dadurch erklären, dass die Halogenanreicherung durch die vergleichsweise großen, an der Grenzfläche lokalisierten Halogen-Atome oder Halogen-Ionen eine Diffusionsbarriere gegen die Eindiffusion von Verunreinigungen wie Kupfer aus der Absorberschicht in die Pufferschicht bilden. Die Halogenatome können auch einen positiven Effekt sowohl auf die elektronische Bandanpassung am Absorber-Puffer-Heteroübergang als auch auf die Rekombination der Ladungsträger an dieser Grenzfläche haben. Um die elektronischen Eigenschaften der Pufferschicht nicht zu verschlechtern soll die Halogenanreicherung in einem engen Schichtbereich der Pufferschicht an der Grenzfläche zur Absorberschicht begrenzt sein.

Zur Erzielung einer Verbesserung des Wirkungsgrads wäre eine Delta-Peak-förmige Halogen-Anreicherung an der Grenzfläche zur Absorberschicht prinzipiell ausreichend. Jedoch ist eine Delta-Peak-förmige Halogen-Anreicherung aufgrund der Oberflächenrauhigkeit der Absorberschicht weder herstellbar noch durch vorhandene Messverfahren überprüfbar. Eine Festlegung der Schichtdicke d₁ im oben genannten Bereich hat sich deshalb als besonders vorteilhaft erwiesen. Für die Einbringung des Halogens wurde auch ein besonders kostengünstiges Verfahren entwickelt, dass zu der beanspruchten Halogenanreicherung führt.

Gleichzeitig wird durch einen Stoffmengenanteil von Zink in der erfindungsgemäßen Pufferschicht die Kurzschlussstromstärke erhöht. Durch die Kombination beider Effekte können besonders vorteilhafte Schichtsysteme erhalten werden. Dazu enthält die erfindungsgemäße Pufferschicht ZnₓIn₁₋ₓS_{y} mit 0,01 ≤ x ≤ 0,9 und 1 ≤ y ≤ 2.

In einer vorteilhaften Ausgestaltung der Erfindung beträgt y von x+(1-x)^{∗}1,3 bis x +(1-x)^{∗}1,5. Wird die ZnₓIn₁₋ₓS_{y}-Pufferschicht durch Verdampfen von In₂S₃ und ZnS oder anderen Verfahren mit Precursoren aus In₂S₃ und ZnS abgeschieden, so gilt y = x+(1- x)^{∗}1,5. Wird beispielsweise ZnS und In₂S₃ im Molverhältnis 2:1 abgeschieden, beträgt x = 0,5 und y = 1,25. Die Pufferschicht enthält dann Zn_{0,5}In_{0,5}S_{1,25}. Wird ein Bruchteil des Schwefels zurückgehalten, beispielsweise durch Verdampfen von In₂S_{2,8} oder Gettern des Schwefels aus dem Dampfraum, so können kleinere Schwefelanteile von beispielsweise y=x+(1-x)^{∗}1,4 oder y=x+(1-x)^{∗}1,3 erzielt werden.

Der Schwefelgehalt y kann bei Verdampfung, aber auch bei anderen Abscheidungen aus den Precursoren ZnS und In₂S₃ beispielsweise durch ein Verfahren gemäß

DE 10 2008 008 518 A1 auch noch kleiner sein. Da die Bandlücke jedoch mit zunehmendem Indiumgehalt abnimmt, sollte der Schwefelgehalt nicht kleiner als y = 1 sein, was einer Verbindung aus ZnS und InS entspricht. Der Schwefelgehalt y kann durch die Exposition der Verdampferquellen in einer schwefelhaltigen Atmosphäre auch größer als y = x+(1-x)^{∗}1,5 sein.

In einer weiteren vorteilhaften Ausgestaltung eines erfindungsgemäßen Schichtsystems beträgt das Verhältnis der Halogen-Stoffmengenanteile A₁/A₂ von 2 bis 1000, bevorzugt von 9 bis 1000 und besonders bevorzugt von 10 bis 100. In diesem Bereich lassen sich besonders gute Wirkungsgrade erzielen.

In einer vorteilhaften Ausgestaltung der Erfindung enthält der Chalkogenidverbindungshalbleiter Cu(In,Ga,Al)(S,Se)₂ und bevorzugt CuInSe₂, CuInS₂, Cu(In,Ga)Se₂ oder Cu(In,Ga)(S,Se)₂, oder Cu₂ZnSn(S,Se)₄. In einer weiteren vorteilhaften Ausgestaltung des erfindungsgemäßen Schichtsystems besteht die Absorberschicht im wesentlichen aus dem Chalkogenidverbindungshalbleiter Cu₂ZnSn(S,Se)₄ oder Cu(In,Ga,Al)(S,Se)₂ und bevorzugt aus CuInSe₂, CuInS₂, Cu(In,Ga)Se₂ oder Cu(In,Ga)(S,Se)₂. Insbesondere umfasst die Absorberschicht Cu(In,Ga)(S,Se)₂ mit einem Verhältnis der Stoffmengenanteile von [S]/([Se]+[S]) an der Oberfläche der Absorberschicht zwischen 10% und 90%, insbesondere 20% bis 65% und bevorzugt 35%, wodurch der Schwefel in das Anionengitter der Chalkopyritstruktur eingebaut wird. Hierdurch lässt sich eine Feinabstimmung der Bandlücke und der Bandanpassung gegenüber dem Indiumsulfid der Pufferschicht erreichen und damit besonders hohe Wirkungsgrade erzielen.

Die Anreicherung der Pufferschicht erfolgt durch ein Halogen, ein Halogenid oder eine Halogen-Verbindung. Das Halogen ist bevorzugt Chlor, Brom oder Iod. Die Anreicherung erfolgt bevorzugt durch Abscheidung von einer oder mehreren Metall-Halogenid-Verbindungen der Gruppe Metall-Chlorid, Metall-Bromid oder Metall-Iodid. Die Verwendung von Metall-Fluorid-Verbindungen ist ebenfalls möglich, wobei diese durch ihre geringe Masse und ihren geringen Atomradius sehr leicht aus der Anreicherungszone wegdiffundieren.

Das Metall der Metall-Halogenid-Verbindung ist vorteilhafterweise ein Alkalimetall, bevorzugt Natrium oder Kalium, ein Element der Gruppe IIIa, bevorzugt Indium oder ein Nebengruppenelement der Gruppe IIb, bevorzugt Zink. Bevorzugte Metall-Halogenid-Verbindungen sind demnach Natriumchlorid, Zinkchlorid, Indiumchlorid, Natriumbromid, Kaliumchlorid und Kaliumbromid.

Natrium ist in Chalkogenidabsorberschichten entweder durch Diffusion aus dem Kalknatronglassubstrat oder durch gezielte Zugabe vorhanden. Die Anreicherung von Alkalimetallen und insbesondere Natrium an der Grenzfläche kann auch ein weiterer Vorteil der Verwendung von Natriumchlorid sein. So unterdrückt Natrium die Eindiffusion von Kupfer in die Indiumsulfid-Pufferschicht, was die Bandlücke in der Pufferschicht verkleinern würde.

Neben den Natrium- und Kaliumverbindungen ist die Verwendung von Zink-Halogenid-Verbindungen, insbesondere von Zinkchlorid oder Indium-Halogenid-Verbindungen, insbesondere von Indiumchlorid besonders vorteilhaft, da Zink und Indium Bestandteile der Pufferschicht sind und dadurch kein Fremdmetall in die erfindungsgemäße Schichtstruktur eingebracht wird.

Wie Untersuchungen der Erfinder ergaben, sind höhere Konzentrationen von Sauerstoff oder Wasserstoff nicht erwünscht, da sie sich negativ auf die Feuchtestabilität auswirken. In einem erfindungsgemäßen ersten Schichtbereich beträgt der lokale Stoffmengenanteil des Halogens vorzugsweise mindestens das Zweifache des lokalen Stoffmengenanteils von Sauerstoff und/oder Kohlenstoff. Lokal bedeutet hier an jeder Stelle des ersten Schichtbereichs in einem mit einem Messverfahren zugänglichen Messvolumen.

In einer vorteilhaften Ausgestaltung eines erfindungsgemäßen Schichtsystems entspricht die Menge des Halogens im ersten Schichtbereich einer Flächenbelegung von 1•10¹³ Atomen/cm² bis 1•10¹⁷ Atomen/cm² und bevorzugt von 2•10¹⁴ Atomen/cm² bis 2•10¹⁶ Atomen/cm². Auch hier umfasst der Begriff Menge des Halogens Atome und Ionen des Halogenelements aller vorhandenen Oxidationsstufen. Für eine Flächenbelegung im oben angegebenen Bereich konnten besonders hohe Wirkungsgrade gemessen werden.

In einer weiteren vorteilhaften Ausgestaltung eines erfindungsgemäßen Schichtsystems weist der Halogen-Stoffmengenanteil in der Pufferschicht einen Gradienten auf, der von der der Absorberschicht zugewandten Oberfläche zum Inneren der Pufferschicht abfällt. Durch die kontinuierliche Abnahme des Halogen-Anteils entsteht ein besonders vorteilhafter Übergang zwischen den Bandstrukturen des ersten und zweiten Schichtbereichs der Pufferschicht.

Die Schichtdicke d einer erfindungsgemäßen Pufferschicht beträgt bevorzugt von 5 nm bis 150 nm und besonders bevorzugt von 15 nm bis 50 nm. Für derartige Schichtdicken konnten besonders hohe Wirkungsgrade erzielt werden.

In einer vorteilhaften Ausgestaltung des erfindungsgemäßen Schichtsystems sind nur die lokalen Stoffmengenanteile von Indium, Schwefel, Natrium, Zink und dem Metall der Metall-Halogenid-Verbindung größer als die lokalen Stoffmengenanteile des Halogens. Bevorzugt enthält die Pufferschicht keine Verunreinigungen, das heißt sie ist nicht absichtlich mit weiteren Elementen, wie Sauerstoff oder Kohlenstoff versehen und enthält diese höchstens im Rahmen fertigungstechnisch nicht vermeidbarer Konzentrationen von kleiner gleich 5 Mol %. Dadurch lässt sich ein hoher Wirkungsgrad sicherstellen.

Ein weiterer Aspekt der Erfindung umfasst Solarzellen und insbesondere Dünnschichtsolarzellen mit dem erfindungsgemäßen Schichtsystem sowie Solarzellenmodule, die diese Solarzellen beinhalten.

Eine erfindungsgemäße Solarzelle umfasst mindestens:
- ein Substrat,
- eine Rückelektrode, die auf dem Substrat angeordnet ist,
- ein erfindungsgemäßes Schichtsystem, das auf der Rückelektrode angeordnet ist und
- eine Frontelektrode, die auf der zweiten Pufferschicht angeordnet ist.

Das Substrat ist vorzugsweise ein Metall, Glas-, Kunststoff oder Keramiksubstrat, wobei Glas bevorzugt wird. Es können aber auch andere transparente Trägermaterialien, insbesondere Kunststoffe verwendet werden.

Die Rückelektrode umfasst vorteilhafterweise Molybdän (Mo) oder andere Metalle. In einer vorteilhaften Ausgestaltung der Rückelektrode weist diese eine Molybdänteilschicht auf, die an die Absorberschicht angrenzt, und eine Siliziumnitridteilschicht (SiN), die an die Molybdän-Teilschicht angrenzt. Derartige Rückelektroden sind beispielsweise aus EP 1356528 A1 bekannt.

Die erfindungsgemäße Solarzelle enthält vorteilhafterweise eine Frontelektrode aus einem transparenten leitenden Oxid (TCO), bevorzugt Indiumzinnoxid (ITO) und/oder Zinkoxid (ZnO), wobei dotiertes ZnO, insbesondere Al- oder Ga-dotiertes ZnO besonders bevorzugt werden.

In einer vorteilhaften Ausgestaltung einer erfindungsgemäßen Solarzelle ist zwischen dem Schichtsystem und der Frontelektrode eine zweite Pufferschicht angeordnet. Die zweite Pufferschicht enthält bevorzugt undotiertes Zinkoxid und/oder undotiertes Zink-Magnesiumoxid.

Die mit diesem Schichtsystem hergestellten Solarzellen zeigen hohe Wirkungsgrade bei gleichzeitig hoher Langzeitstabilität. Da nunmehr keine toxischen Substanzen mehr zum Einsatz kommen, ist das Herstellungsverfahren umweltschonender und billiger und es entstehen auch keine Nachfolgekosten, wie bei CdS-Pufferschichten.

Die Erfindung umfasst des Weiteren ein Verfahren zur Herstellung eines erfindungsgemäßen Schichtsystems, wobei zumindest
a) eine Absorberschicht (4) bereitgestellt wird und
b) eine Pufferschicht (5), die Halogen-angereichertes ZnₓIn₁₋ₓS_{y} mit 0,01 ≤ x ≤ 0,9 und 1 ≤ y ≤ 2 enthält, auf der Absorberschicht (4) angeordnet wird,
wobei die Pufferschicht (5) aus einem an die Absorberschicht (4) angrenzenden ersten Schichtbereich (5.1) mit einem Halogen-Stoffmengenanteil A₁ und einem an den ersten Schichtbereich (5.1) angrenzenden zweiten Schichtbereich (5.2) mit einem Halogen-Stoffmengenanteil A₂ besteht und das Verhältnis A₁/A₂ ≥ 2 beträgt.

Zweckmäßig wird die Absorberschicht in einem RTP-("rapid thermal processing") Prozess auf die Rückelektrode auf einem Substrat aufgebracht. Für Cu(In,Ga)(S,Se)₂-Absorberschichten wird dabei zunächst eine Vorläuferschicht auf das Substrat mit Rückelektrode abgeschieden. Die Vorläuferschicht enthält die Elemente Kupfer, Indium und Gallium, die durch Sputtern aufgebracht werden. Bei der Beschichtung durch die Vorläuferschichten wird eine gezielte Natriumdosis in die Vorläuferschichten eingebracht, wie beispielsweise aus EP 715 358 B1 bekannt ist. Des Weiteren enthält die Vorläuferschicht elementares Selen, das durch thermisches Verdampfen aufgebracht wird. Bei diesen Prozessen liegt die Substrattemperatur unter 100°C, so dass die Elemente im Wesentlichen als Metalllegierung und elementares Selen unreagiert erhalten bleiben. Anschließend wird diese Vorläuferschicht in einem schnellen Temperverfahren (rapid thermal processing, RTP) in schwefelhaltiger Atmosphäre zu einem Cu(In,Ga)(S,Se)₂-Chalcopyrithalbleiter reagiert.

Zur Herstellung der Pufferschicht sind prinzipiell alle chemisch-physikalischen Abscheideverfahren geeignet, bei denen das Stoffmengenverhältnis von Halogen oder Halogenid zu Zinkindiumsulfid, sowie das Verhältnis von Zink zu Indium und Indium zu Schwefel im gewünschten Bereich gesteuert werden kann.

Die erfindungsgemäße Pufferschicht wird vorteilhafterweise durch Atomic Layer Deposition (ALD), Ion Layer Gas Deposition (ILGAR), Spray Pyrolose, Chemical Vapour Deposition (CVD) oder Physical Vapor Deposition (PVD) auf die Absorberschicht aufgebracht. Die erfindungsgemäße Pufferschicht wird bevorzugt durch Sputtern, thermisches Verdampfen oder Elektronenstrahlverdampfen abgeschieden, besonders bevorzugt aus separaten Quellen für das Halogen und Indiumsulfid und Zinksulfid. Indiumsulfid kann entweder aus getrennten Quellen für Indium und Schwefel verdampft werden oder aus einer Quelle mit einem In₂S₃-Verbindungshalbleitermaterial. Auch andere Indiumsulfide (In₅S₆/S₇ oder InS) sind in Kombination mit einer Schwefelquelle möglich.

Das Halogen wird bevorzugt aus einer Metall-Halogen-Verbindung und besonders bevorzugt aus einer Metall-Halogenid-Verbindung eingebracht. Besonders geeignete Metall-Halogenid-Verbindungen sind Natriumchlorid, Natriumbromid, Kaliumchlorid, Kaliumbromid, Zinkchlorid und/oder Indiumchlorid. Diese Metall-Halogenid-Verbindungen sind besonders vorteilhaft, da sie nur eine geringe Giftigkeit, eine gute Verarbeitbarkeit und eine einfache Integrierbarkeit in vorhandene technische Prozesse aufweisen. Bevorzugt ist das Halogenelement Chlor, da im Experiment die größten Wirkungsgraderhöhungen nachgewiesen wurden.

Zur Abscheidung einer Metall-Halogenid-Verbindung und insbesondere von Natriumchlorid, Kaliumchlorid, Indiumchlorid und Zinkchlorid vor der Beschichtung mit Zinkindiumsulfid können sowohl nasschemische als auch trockene, auf Vakuumtechnik basierende Verfahren verwendet werden.

Als nasschemische Verfahren zur Abscheidung einer Metall-Halogenid-Verbindung können insbesondere Dip-Coaten, Besprühen, Aerosol-Sprühen, Übergießen, Tauchen oder Waschen des Absorbers mit einer Metall-Halogenid-haltigen Lösung (beispielsweise mit Wasser als Lösungsmittel) verwendet werden. Das Trocknen der Absorberschicht nach der Abscheidung kann entweder bei Raumtemperatur oder bei erhöhten Temperaturen erfolgen. Bei Bedarf kann das Trocknen über ein Abblasen mit gasförmigem Stickstoff über ein sogenanntes Airknife unterstützt werden, so dass eine homogene Metall-Halogenid-Schicht auf dem Absorber entsteht.

Das Ion Layer Gas Deposition (ILGAR)-Verfahren eignet sich ebenfalls, wenn man mit geeigneten Precursoren den Halogengradienten und den Zink-Gehalt einstellt.

Die erfindungsgemäße Pufferschicht wird vorteilhafterweise mit einem Vakuumverfahren abgeschieden. Das Vakuumverfahren hat den besonderen Vorteil, dass im Vakuum der Einbau von Sauerstoff oder Hydroxid verhindert wird. Hydroxid-Komponenten in der Pufferschicht sind vermutlich verantwortlich für Transienten des Wirkungsgrades bei Einwirkung von Wärme und Licht. Des Weiteren haben Vakuumverfahren den Vorteil, dass das Verfahren ohne Nasschemie auskommt und Standard-Vakuumbeschichtungsanlagen verwendet werden können.

Ein weiterer Vorteil des Vakuumprozesses besteht darin, dass eine höhere Materialausbeute erzielt werden kann. Außerdem sind Vakuumprozesse im Gegensatz zur Nassabscheidung umweltverträglicher, da beispielsweise im Gegensatz zur chemischen Badabscheidung keine kontaminierten Abwässer erzeugt werden. Des Weiteren können verschiedene Vakuumprozesse, wie auch die Herstellung der zweiten undotierten ZnO-Pufferschicht oder der dotierten ZnO-Frontelektrode in einer Anlage verbunden werden, wodurch die Herstellung preiswerter erfolgen kann. Je nach Ausgestaltung des Prozesses zur Herstellung der Absorberschicht ist auch eine Kombination der Herstellung von Absorberschicht und Pufferschicht ohne zwischenzeitliche Luftexposition denkbar.

Das thermische Verdampfen im Vakuum hat den Vorteil, dass das Verfahren ohne Nasschemie auskommt und Standard Vakuumbeschichtungsanlagen verwendet werden können. Während des thermischen Verdampfens wird in einer Vakuumumgebung direkt die Metall-Halogen-Verbindung auf der Absorberschicht aufgebracht und die Absorberschicht mit der Metall-Halogen-Schicht kann dann ohne Vakuumbruch mit Zinkindiumsulfid bedampft werden.

In einer besonders vorteilhaften Ausführungsform des erfindungsgemäßen Verfahrens wird die Metall-Halogen-Verbindung aus einer Quelle und Zinkindiumsulfid aus zwei weiteren separaten Quellen, einer Indiumsulfid-Quelle und einer Zinksulfid-Quelle verdampft. Die Anordnung der Abscheidungsquellen ist derart gestaltet, dass sich die Dampfkeulen der Quellen nicht, ganz oder teilweise überlappen. Dampfkeule im Sinne der vorliegenden Anmeldung bedeutet der Bereich vor dem Auslass der Quelle, welcher für die Abscheidung des verdampften Materials auf einem Substrat hinsichtlich Aufdampfrate und Homogenität technisch geeignet ist.

Die Halogen-Quelle, die Indiumsulfid-Quelle und/oder die Zinksulfid-Quelle sind beispielsweise Effusionszellen, aus denen eine Metall-Halogen-Verbindung wie Natriumchlorid, Zinkchlorid oder Indiumchlorid beziehungsweise Indiumsulfid und Zinksulfid thermisch verdampft wird. Alternativ ist jede andere Form der Erzeugung von Dampfkeulen zur Abscheidung der Pufferschicht geeignet, sofern sich das Verhältnis der Stoffmengenanteile von Chlor, Zink, Indium und Schwefel steuern lässt. Alternative Quellen sind beispielsweise Schiffchen von Linearverdampfern oder Tiegel von Elektronenstrahlverdampfern.

In einer beispielhaften Ausgestaltung des erfindungsgemäßen Verfahrens wird die Absorberschicht in einem In-Line-Verfahren an Dampfkeulen von Natriumchlorid und Dampfkeulen von Indiumsulfid und Zinksulfid vorbeigeführt. Die Dampfkeulen überlappen sich nicht, ganz oder teilweise. Zusätzlich kann die Aufdampfrate der einzelnen Quellen mit Blenden oder über die Temperatur gesteuert werden. Allein durch die Verdampfungsgeometrie und die Einstellung der Raten kann somit ein Halogengradient eingestellt werden.

In einer alternativen Ausführungsform des erfindungsgemäßen Verfahrens wird im zweiten Schritt b) zunächst eine Metall-Halogenid-Verbindung auf der Absorberschicht abgeschieden. Beispielsweise wird Natriumchlorid aus einer Effusionszelle verdampft. Die verdampfte Menge an Natriumchlorid wird durch Öffnen und Schließen einer Blende oder durch eine Temperatursteuerung gesteuert. Anschließend wird in einem weiteren Schritt eine Pufferschicht aus Zinkindiumsulfid, bevorzugt ohne Vakuumunterbrechung, auf der mit Natriumchlorid belegten Absorberschicht abgeschieden.

In einer alternativen Ausführungsform des erfindungsgemäßen In-Line-Verfahrens zur Herstellung einer erfindungsgemäßen Pufferschicht sind eine Halogen-Quelle, eine Indiumsulfid-Quelle und eine Zinksulfid-Quelle derart hintereinander angeordnet, dass die Dampfkeulen der Indiumsulfid-Quelle und der Zinksulfid-Quelle nahezu vollständig überlappen. Diese dadurch gebildete Misch-Dampfkeule überlappt sich zumindest teilweise mit der Dampfkeule der Halogen-Quelle, bevorzugt von 10 % bis 70% und besonders bevorzugt von 25 % bis 50 %. Auf diese Weise lässt sich ein Gradient mit einer kontinuierlichen Abnahme der Halogen-Konzentration in der Pufferschicht ausbilden, was besonders vorteilhaft für die Eigenschaften der erfindungsgemäßen Solarzelle ist.

Ein weiterer Aspekt der Erfindung umfasst eine Vorrichtung zur Herstellung einer erfindungsgemäßen Pufferschicht in einem In-Line-Verfahren, wobei mindestens eine Halogen-Quelle, mindestens eine Indiumsulfid-Quelle und mindestens eine Zinksulfid-Quelle derart hintereinander angeordnet, dass sich die Dampfkeule der Halogen-Quelle und die Misch-Dampfkeule von Indiumsulfid und Zinksulfid zumindest teilweise überlappen, bevorzugt von 10 % bis 70% und besonders bevorzugt von 25 % bis 50 %.

Die Erfindung wird nachfolgend anhand einer Zeichnung und eines Beispiels näher erläutert. Die Zeichnung ist nicht vollständig maßstabsgetreu. Die Erfindung wird durch die Zeichnung in keiner Weise eingeschränkt. Es zeigen:
- Fig. 1: eine schematische Querschnittsansicht einer Solarzelle mit einem erfindungsgemäßen Schichtsystem,
- Fig. 2: ein Diagramm der Transmission einer ZnₓIn₁₋ₓS_{y}-Pufferschicht auf Glas für verschiedene Verhältnisse x,
- Fig. 3: ein Diagramm der Kurzschlussstromstärke einer Solarzelle mit ZnₓIn₁₋ₓS_{y}-Pufferschicht,
- Fig. 4: ein Diagramm des Tiefenprofil von Chlor einer erfindungsgemäßen Schichtstruktur mit Vergleichsbeispiel,
- Fig. 5: ein Diagramm des Tiefenprofils der Chlor-, Kupfer-, Indium-, Schwefelund Selen-Konzentration einer erfindungsgemäßen Schichtstruktur,
- Fig. 6: ein Diagramm der Photolumineszenzlebensdauer einer erfindungsgemäßen Schichtstruktur mit Vergleichsbeispiel,
- Fig. 7: ein Diagramm des Wirkungsgrads einer erfindungsgemäßen Schichtstruktur mit Vergleichsbeispielen,
- Fig. 8: ein Diagramm des Wirkungsgrads einer weiteren erfindungsgemäßen Schichtstruktur mit Vergleichsbeispiel,
- Fig. 9 A: ein Diagramm des Wirkungsgrads einer erfindungsgemäßen Schichtstruktur mit Vergleichsbeispiel,
- Fig. 9 B: ein Diagramm der Leerlaufspannung einer alternativen erfindungsgemäßen Schichtstruktur mit Vergleichsbeispiel,
- Fig. 10: ein Ausführungsbeispiel der erfindungsgemäßen Verfahrensschritte anhand eines Flussdiagramms,
- Fig. 11: eine schematische Darstellung eines In-Line-Verfahrens zur Herstellung einer erfindungsgemäßen Pufferschicht,
- Fig. 12: eine schematische Darstellung eines alternativen In-Line-Verfahrens zur Herstellung einer erfindungsgemäßen Pufferschicht.

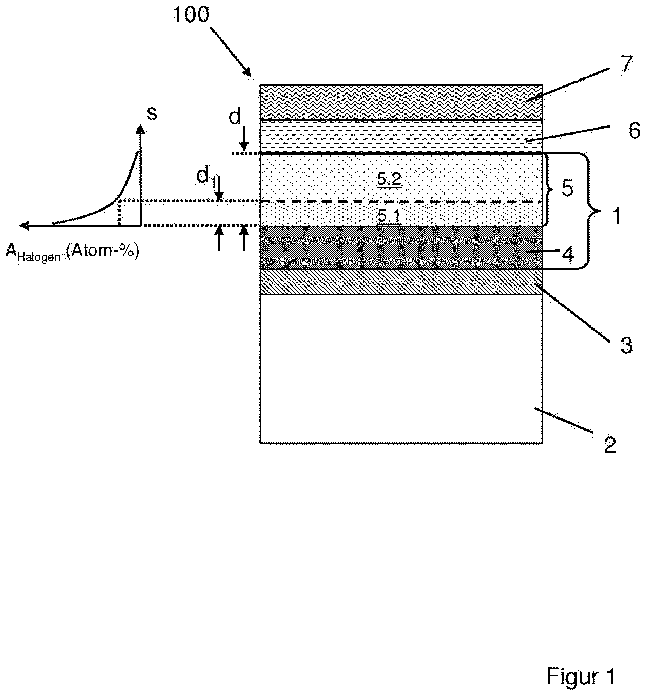

Figur 1 zeigt rein schematisch ein bevorzugtes Ausführungsbeispiel einer erfindungsgemäßen Dünnschichtsolarzelle 100 mit einem erfindungsgemäßen Schichtsystem 1 in einer Querschnittsansicht. Die Dünnschichtsolarzelle 100 enthält ein Substrat 2 und eine Rückelektrode 3. Auf der Rückelektrode 3 ist ein erfindungsgemäßes Schichtsystem 1 angeordnet. Das erfindungsgemäße Schichtsystem 1 umfasst eine Absorberschicht 4 und eine Pufferschicht 5. Auf dem Schichtsystem 1 ist eine zweite Pufferschicht 6 und eine Frontelektrode 7 angeordnet.

Das Substrat 2 besteht hier beispielsweise aus anorganischem Glas, wobei gleichermaßen andere isolierende Materialien mit genügender Festigkeit, sowie inertem Verhalten gegenüber den bei der Herstellung der Dünnschichtsolarzelle 100 durchgeführten Prozessschritten eingesetzt werden können, beispielsweise Kunststoffe, insbesondere Polymere oder Metalle, insbesondere Metall-Legierungen. In Abhängigkeit der Schichtdicke und den spezifischen Materialeigenschaften kann das Substrat 2 als starre Platte oder biegsame Folie ausgestaltet sein. Im vorliegenden Ausführungsbeispiel beträgt die Schichtdicke des Substrats 2 beispielsweise von 1 mm bis 5 mm.

Auf der lichteintrittsseitigen Oberfläche des Substrats 2 ist eine Rückelektrode 3 angeordnet. Die Rückelektrode 3 besteht beispielsweise aus einem lichtundurchlässigen Metall. Sie kann beispielsweise durch Aufdampfen oder magnetfeldunterstützte Kathodenzerstäubung auf dem Substrat 2 abgeschieden werden. Die Rückelektrode 3 besteht beispielsweise aus Molybdän (Mo), Aluminium (Al), Kupfer (Cu), Titan (Ti) oder aus einem Mehrschichtsystem mit einem solchen Metall, beispielsweise Molybdän (Mo). Die Schichtdicke der Rückelektrode 3 ist hier geringer als 1 µm, liegt vorzugsweise im Bereich von 300 nm bis 600 nm und beträgt beispielsweise etwa 500 nm. Die Rückelektrode 3 dient als Rückseitenkontakt der Solarzelle 100. Zwischen dem Substrat 2 und der Rückelektrode 3 kann eine Alkali-Barriere angeordnet sein, welche beispielsweise aus Si₃N₄, SiON oder SiCN besteht. Diese ist in Figur 1 nicht näher dargestellt.

Auf der Rückelektrode 3 ist ein erfindungsgemäßes Schichtsystem 1 angeordnet. Das Schichtsystem 1 enthält eine Absorberschicht 4, beispielsweise aus Cu(In,Ga)(S,Se)₂, die unmittelbar auf der Rückelektrode 3 aufgebracht ist. Die Absorberschicht 4 hat beispielsweise eine Dicke von 1,5 µm.

Auf der Absorberschicht 4 ist eine Pufferschicht 5 angeordnet. Die Pufferschicht 5 enthält ZnₓIn₁₋ₓS_{y} mit 0,01 ≤ x ≤ 0,9,und 1 ≤ y ≤ 2 und beispielsweise Zn_{0,1}In_{0,9}S_{1,45}. Die Schichtdicke d der Pufferschicht 5 beträgt von 5 nm bis 150 nm und beispielsweise 35 nm. Die Pufferschicht 5 besteht aus einem ersten Schichtbereich 5.1, der an die Absorberschicht 4 angrenzt und flächig mit der Absorberschicht 4 verbunden ist. Des Weiteren umfasst die Pufferschicht 5 einen zweiten Schichtbereich 5.2, der auf dem ersten Schichtbereich 5.1 angeordnet ist. Der erste Schichtbereich hat eine Dicke d₁, die ≤ 50 % der Schichtdicke d der gesamten Pufferschicht 5 besteht. Die Dicke d₁ des ersten Schichtbereichs 5.1 beträgt beispielsweise 10 nm. Der erste Schichtbereich 5.1 enthält einen Halogen-Stoffmengenanteil A₁ und der zweite Schichtbereich 5.2 einen Halogen-Stoffmengenanteil A₂. Das Verhältnis der Halogen-Stoffmengenanteile A₁/A₂ beträgt ≥ 2 und beispielsweise 10. Zur Verdeutlichung ist in Figur 1 ein beispielhafter Verlauf des Halogen-Stoffinengenanteils A_{Halogen} in Abhängigkeit der Schichttiefe s dargestellt. Die Angabe des Halogen-Stoffmengenanteils A_{Halogen} ist in Atom-% aufgetragen, wobei der Halogen-Stoffmengenanteil gleichwohl Halogen-Ionen und Halogen in Verbindungen umfasst.

Oberhalb der Pufferschicht 5 kann eine zweite Pufferschicht 6 angeordnet sein. Die Pufferschicht 6 enthält beispielsweise undotiertes Zinkoxid. Oberhalb der zweiten Pufferschicht 6 ist eine Frontelektrode 7 angeordnet, die als Vorderseitenkontakt dient und für Strahlung im sichtbaren Spektralbereich transparent ist ("Fensterschicht"). In der Regel wird für die Frontelektrode 7 ein dotiertes Metalloxid (TCO = Transparent Conductive Oxide) eingesetzt, beispielsweise n-leitendes, Aluminium (Al)-dotiertes Zinkoxid (ZnO), Bor (B)-dotiertes Zinkoxid (ZnO), oder Gallium (Ga)-dotiertes Zinkoxid (ZnO). Die Schichtdicke der Frontelektrode 7 beträgt beispielsweise etwa 300 bis 1500 nm. Zum Schutz vor Umwelteinflüssen kann auf der Frontelektrode 7 eine beispielsweise aus Polyvinylbutyral (PVB), Ethylenvinylacetat (EVA) oder DNP bestehende Kunststoffschicht (Verkapselungsfolie) aufgebracht sein. Zudem kann eine für Sonnenlicht transparente Deckplatte, die beispielsweise aus extraweißem Glas (Frontglas) mit geringem Eisengehalt besteht und eine Dicke von beispielsweise 1 bis 4 mm aufweisen kann, vorgesehen sein.

Der beschriebene Aufbau einer Dünnschichtsolarzelle bzw. eines Dünnschichtsolarmoduls ist dem Fachmann beispielsweise aus im Handel verfügbaren Dünnschichtsolarzellen bzw. Dünnschichtsolarmodulen wohlbekannt und wurde zudem bereits in zahlreichen Druckschriften der Patentliteratur eingehend beschrieben, beispielsweise in DE 19956735 B4.

In der in Figur 1 gezeigten Substratkonfiguration grenzt die Rückelektrode 3 an das Substrat 2 an. Es versteht sich, dass das Schichtsystem 1 gleichermaßen über eine Superstratkonfiguration verfügen kann, bei welcher das Substrat 2 transparent und die Frontelektrode 7 auf einer der Lichteintrittsseite abgewanden Oberfläche des Substrats 2 angeordnet ist.

Das Schichtsystem 1 kann zur Herstellung von integriert serienverschalteten Dünnschichtsolarzellen dienen, wobei das Schichtsystem 1, die Frontelektrode 7 und die Rückelektrode 3 in an sich bekannter Weise durch verschiedene Strukturierungslinien ("P1" für Rückelektrode, "P2" für Kontakt Frontelektrode/Rückelektrode und "P3" für Trennung der Frontelektrode) strukturiert wird.

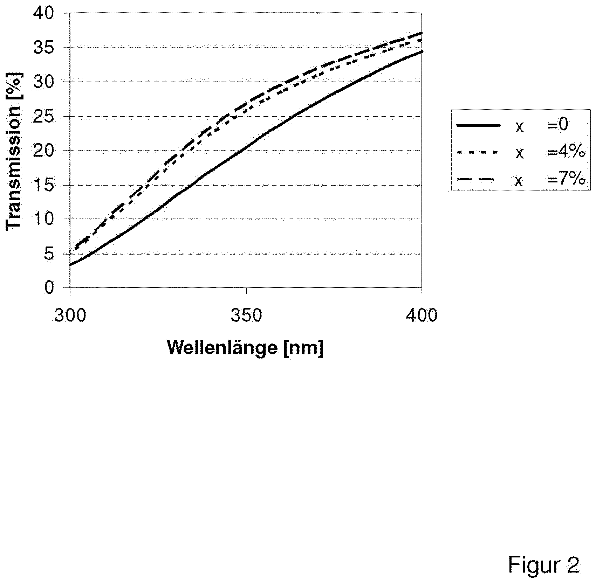

Figur 2 zeigt die Transmission von ZnₓIn₁₋ₓS_{y}-Schichten auf Glas für verschiedene x in Abhängigkeit von der Wellenlänge. Als Vergleichsbeispiel dient eine Pufferschicht nach dem Stand der Technik mit x = 0 %, also eine In₂S₃-Schicht ohne Zink-Anteil.

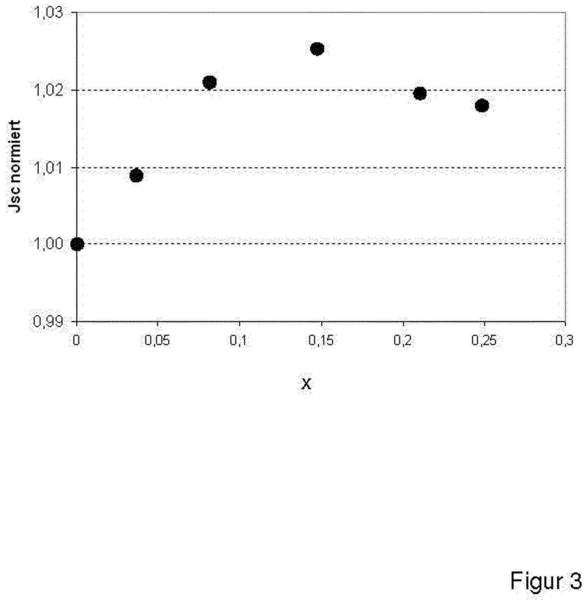

Man erkennt eine Zunahme der Transmission über den gesamten Wellenlängenbereich von 300 nm bis 400 nm für ansteigende Verhältnisse von x. Die Zunahme der Transmission ist überraschend für diese geringen Beimengungen von Zink, da die Bandlücke sich gemäß für Verhältnisse x < 10% nur geringfügig ändert. In der Solarzelle macht sich dies erwartungsgemäß in einer Erhöhung des Kurzschlussstroms bemerkbar, wie Figur 3 zeigt.

Figur 3 zeigt ein Diagramm des Kurzschlussstroms J_{SC} von Solarzellen mit ZnₓIn₁₋ₓS_{y}-Pufferschichten 5 in Abhängigkeit von x. Der Kurzschlussstrom Jsc ist normiert auf den Kurzschlussstrom einer Pufferschicht nach dem Stand der Technik mit x = 0, also einer In₂S₃-Pufferschicht ohne Zink-Anteil. Der normierte Kurzschlussstrom hat ein Maximum für x = 0,15 mit J_{SC} = 1,026.

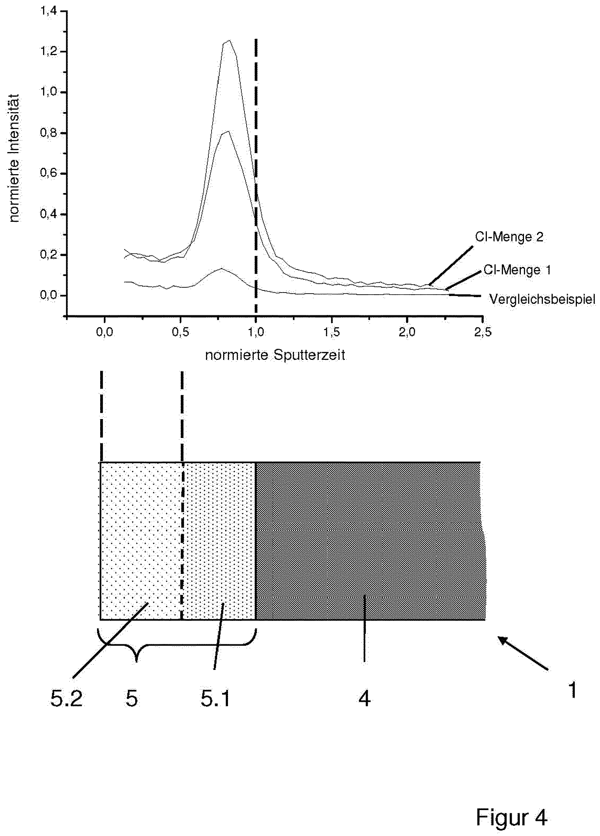

Figur 4 zeigt das Tiefenprofil von Chlor gemessen durch hochaufgelöste Time-of-Flight Secondary Ion Mass Spectrometry (ToF-SIMS) von drei verschieden präparierten Pufferschichten 5 auf einer Absorberschicht 4. Der Chlor-Anteil beschreibt den Anteil aller in der Pufferschicht 5 vorhandenen Chloratome unabhängig von ihrer Oxidationsstufe.

Die Referenzmessung erfolgte an einem Vergleichsbeispiel an einer Indiumsulfid-Pufferschicht nach dem Stand der Technik ohne einen ersten Schichtbereich 5.1 mit Halogenanreicherung. In den Fällen Cl-Menge 1 und Cl-Menge 2 wurden vor der eigentlichen Pufferabscheidung 5 aus Indiumsulfid zwei unterschiedlich hohe Mengen Natriumchlorid auf der Absorberschicht 4 aufgebracht. Die NaCl-Flächenbelegung von Cl-Menge 1 betrug etwa 2 x 10¹⁴ Cl-Atome/cm². Die NaCl-Flächenbelegung von Cl-Menge 2 betrug etwa 3 x 10¹⁴ Cl-Atome/cm² und war um 50 % größer als bei Cl-Menge 1.

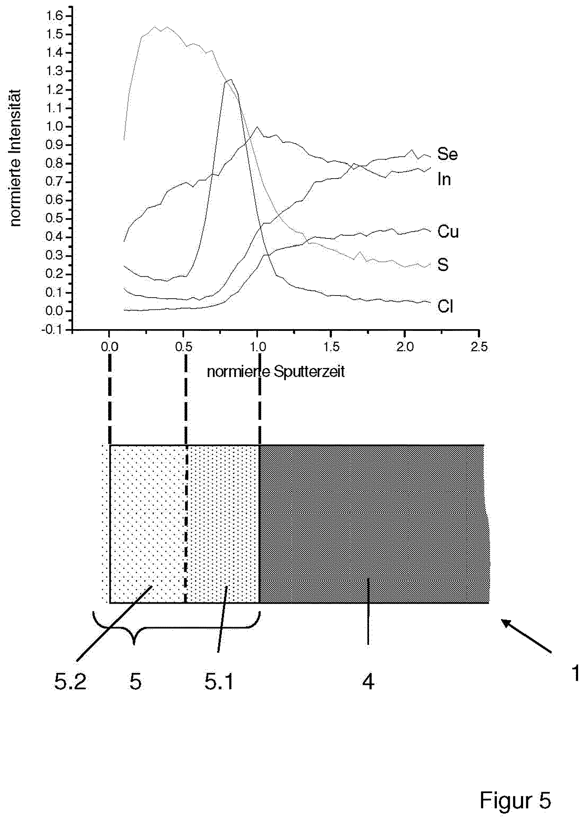

In Figur 5 ist auf der x-Achse die normierte Sputterzeit aufgetragen. Die Sputterzeit entspricht der Sputtertiefe, wobei die Analyse auf der der Absorberschicht 4 abgewandten Oberfläche der Pufferschicht 5 beginnt. Die Pufferschicht 5 entspricht dem Bereich 0 bis 1 auf der x-Achse und die Absorberschicht 4 dem Bereich mit Werten >1. Figur 4 zeigt, dass nach etwas mehr als der Hälfte der Pufferschicht bei einer normierten Sputterzeit von 0,6 ein Chlor-Signal in Delta-Form ansteigt und bei Erreichen des Absorbers bei einer normierten Sputterzeit von etwa 1 wieder auf kleinere Werte abfällt. Die Intensitäten außerhalb des Maximums sind zum Teil auf Diffusion und zum Teil auf Verschmierung des Profils durch die relativ raue Oberflächentopografie der Absorberschicht 4 zurückzuführen. Das Vergleichsbeispiel zeigt ebenfalls kleinere Mengen von Chlorid bei normierten Sputterzeiten zwischen 0,6 und 0,8, die auf Verunreinigungen in den Ausgangsmaterialien zum Verdampfen zurückzuführen sind. Die geringe Belegungsdichte von Chlorid im Vergleichsbeispiel reicht jedoch nicht aus, um eine nennenswert positive Wirkung auf den Wirkungsgrad auszuüben.

Figur 5 zeigt zusätzlich das Tiefenprofil der Chlor-Anreicherung bezüglich der Grenzfläche von Absorberschicht 4 und Pufferschicht 5 anhand Beispiel Cl-Menge 1 aus Figur 4 mit den weiteren Elementen Kupfer, Indium, Schwefel und Selen. Im Bereich der Indiumsulfid-Pufferschicht 5 wurden erwartungsgemäß große Anteile von Schwefel und Indium gemessen und im Bereich der Absorberschicht 4 große Anteile von Kupfer, Selen, Indium und einen geringeren Anteil an Schwefel. Es zeigte sich insbesondere, dass die Intensität des Kupfersignals ab der Grenzfläche zwischen Absorberschicht 4 und Pufferschicht 5 in Richtung Pufferschicht 5 stark abfällt und sich nur wenig mit dem Bereich großer Chlor-Intensitäten überlagert.

Die vorliegende Erfindung beruht daher auf der Erkenntnis der Erfinder, dass die an der Grenzfläche lokalisierten, vergleichsweise großen Halogen-Atome oder Halogen-Ionen wie eine Diffusionsbarriere die Eindiffusion von Verunreinigungen wie Kupfer aus der Absorberschicht 4 in die Pufferschicht 5 reduzieren. Die an der Grenzfläche im ersten Schichtbereich 5.1 lokalisierten Halogen-Atome oder Halogen-Ionen ändern dabei in positiver Weise die elektronischen Eigenschaften der Pufferschicht 5 selbst. Eine Eindiffusion von Kupfer in In₂S₃-Pufferschichten wird beispielsweise bei Barreau et al, Solar Energy 83, 363, 2009 beschrieben und führt über eine Reduktion der Bandlücke zu erhöhten optischen Verlusten. Dies geschieht in erster Linie durch eine Verschiebung des Valenzbandmaximums, was sich wiederum störend auf die Ausbildung der energetisch optimalen Bandstruktur am p-n-Übergang auswirken könnte. Außerdem kann eine erfindungsgemäße Halogen-Anreicherung an der Grenzfläche zwischen Absorberschicht und Pufferschicht eventuell auftretende Defekte elektronisch maskieren und absättigen, so dass diese nicht mehr als Rekombinationszentren elektrisch aktiv sind und dadurch insgesamt den Wirkungsgrad der Solarzelle steigern. Um die Reduktion der Rekombinationszentren nachzuweisen, wurden Messungen der Photolumineszenzlebensdauer an Absorber/Puffer-Heteroübergängen mit verschiedenen Puffern durchgeführt.

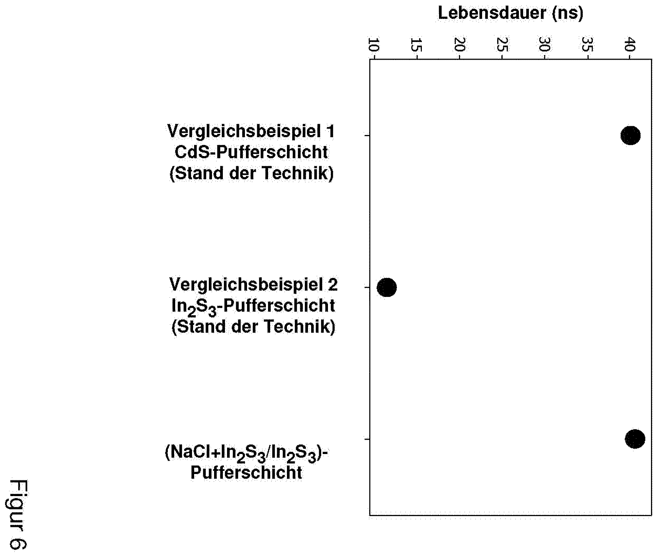

Figur 6 zeigt ein Diagramm der Photolumineszenzlebensdauer für verschiedene Pufferschichten. Die Lebensdauer wurde mit einem Photolumineszenzmessplatz und einem 633 nm-Laser gemessen. Dabei ist die typische Eindringtiefe des Laserlichtes etwa 70 nm. Dies bedeutet, dass die Photolumineszenz der Oberfläche und der oberflächennahen Region (insbesondere der Raumladungszone am pn-Übergang) gemessen wird. Die gemessene Photolumineszenzabklingzeit entspricht einer effektiven Lebensdauer, die sowohl von der Rekombination der Ladungsträger im Volumen als auch von der Rekombination an der Grenzfläche zur Pufferschicht 5 bestimmt wird. In Figur 6 ist die typische Lebensdauer von pn-Übergängen von einer Pufferschicht 5 aus Indiumsulfid mit Chlorid-Anreicherung und zwei Vergleichsbeispiele nach dem Stand der Technik gezeigt.

Vergleichsbeispiel 1 ist eine CdS-Pufferschicht nach dem Stand der Technik. Die gute Lebensdauer von etwa 40 ns in pn-Übergängen mit CdS-Pufferschichten lässt sich auf die sehr gute Reduktion von Grenzflächendefekten aufgrund der nasschemischen Behandlung zurückführen. Vergleichsbeispiel 2 ist eine Pufferschicht nach dem Stand der Technik aus Indiumsulfid ohne Halogen-Anreicherung. Die reine In₂S₃-Pufferschicht führt zu einer deutlichen Reduktion der Lebensdauer auf etwa 10 ns, was auf eine erhöhte Rekombination der Ladungsträger an der Oberfläche und in oberflächennahen Schichten zurückzuführen ist.

Das Beispiel zeigt eine NaCl+In₂S₃/In₂S₃-Pufferschicht 5 wobei vor Abscheidung der Pufferschicht 5 Natriumchlorid auf der Absorberschicht 4 aufgebracht wurde. Dies führt zu einer Ausbildung eines ersten Schichtbereichs 5.1 mit einem Halogen-Stoffmengenanteil A₁. Die Pufferschicht 5 zeigt eine signifikant erhöhte Lebensdauer von etwa 41 ns. Die Lebensdauer in der Pufferschicht 5 des Beispiels liegt im Bereich der Lebensdauer von Vergleichsbeispiel 1, einer CdS-Pufferschicht. Es lässt sich schlussfolgern, dass trotz des trockenen Verfahrens zur Abscheidung der Pufferschicht 5 des Beispiels eine signifikante Reduktion von Grenzflächendefekten erreicht wird. Die Einführung des halogenreichen ersten Schichtbereichs 5.1 führt also im Vergleich zu einer Indiumsulfid-Pufferschicht ohne Halogenanreicherung tatsächlich zu einer Verbesserung der elektronischen Eigenschaften der Absorber-Puffer-Grenzfläche.

Der Wirkungsgrad von Pufferschichten 5 mit einer Halogenid-Anreicherung an der Grenzfläche zur Absorberschicht 4 verbessert sich relativ zu reinen Indiumsulfid-Pufferschichten über einen weiten Bereich bezüglich des Halogen-Stoffmengenanteils A₁ im ersten Schichtbereich 5.1.

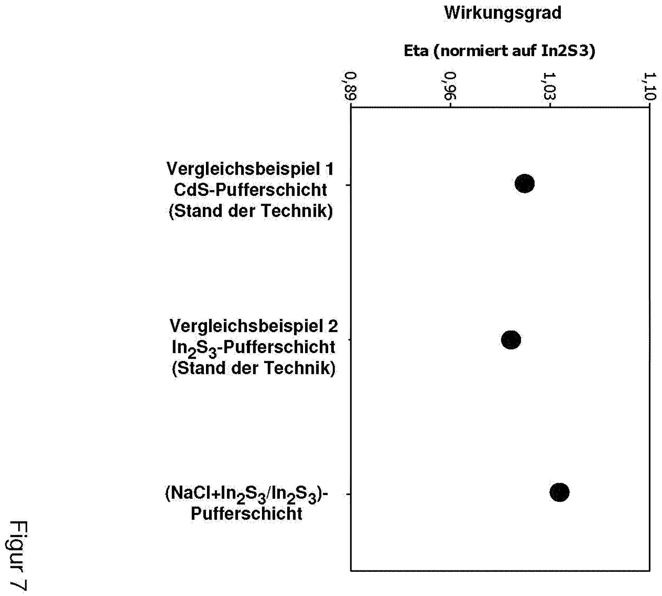

Figur 7 zeigt den Wirkungsgrad von Solarzellen 100 mit einer Pufferschicht 5 mit einer NaCl-Vorbelegung und zwei Vergleichsbeispielen nach dem Stand der Technik. In Vergleichsbeispiel 1 ist die Pufferschicht eine nasschemisch abgeschiedene CdS-Schicht. In Vergleichsbeispiel 2 ist die Pufferschicht eine aus der Gasphase abgeschiedene Indiumsulfidschicht ohne Halogen-Anreicherung. Die Pufferschicht 5 wurde durch eine NaCl-Vorbelegung durch Vorverdampfen von Natriumchlorid auf die Absorberschicht 4 hergestellt. Anschließend wurde auf die NaCl-Vorbelegung Indiumsulfid aus der Gasphase abgeschieden. Wie Figur 7 zu entnehmen ist, werden mit der Pufferschicht 5 mit NaCl-Vorbelegung die höchsten Wirkungsgrade von durchschnittlich 1,04 normiert auf den Wirkungsgrad von Vergleichsbeispiel 2, also einer In₂S₃-Pufferschicht nach dem Stand der Technik ohne Halogen-Anreicherung, erreicht.

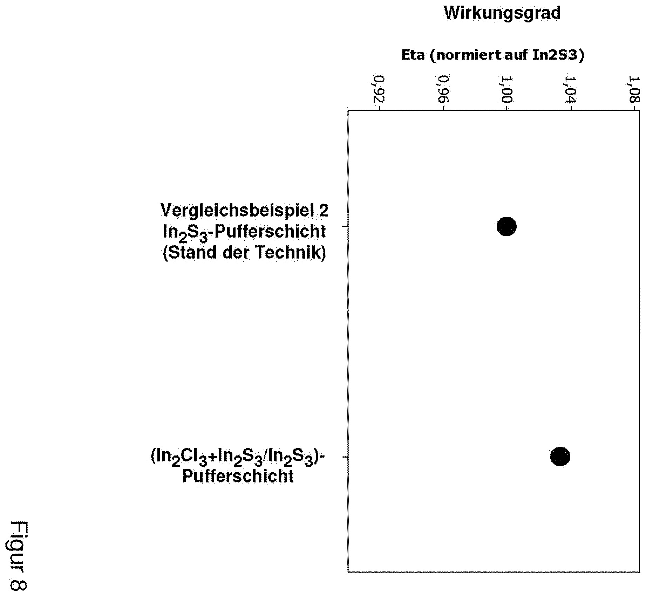

Figur 8 zeigt die Messung des Wirkungsgrads für eine In₂S₃-Pufferschicht nach dem Stand der Technik ohne InCl₃-Vorbelegung im Vergleich zum Wirkungsgrad einer alternativen Pufferschicht 5 mit einer Halogen-Anreicherung durch eine Vorbelegung mit Indiumchlorid (InCl3). Auch eine InCl₃-Vorbelegung führt zu einer Halogen-Anreicherung im ersten Schichtbereich 5.1 an der Grenzfläche zur Absorberschicht 4, die die Grenzfläche dotiert und außerdem die Oberflächendefekte reduziert. Figur 8 zeigt deutlich, dass die Halogen-Anreicherung der erfindungsgemäßen Pufferschicht 5 den Wirkungsgrad von Solarzellen 100 steigert. Die Steigerung des Wirkungsgrades mit der InCl₃-Vorbelegung beträgt in diesem Fall etwa 4 % und liegt in der gleichen Größenordnung wie mit einer NaCl-Vorbelegung in Figur 7.

Neben den Elementen Indium, Schwefel und Chlor können sich in der Pufferschicht 5 auch Kupfer, Sauerstoff und Selen befinden. Indiumsulfid hat eine relative offene Gitterstruktur, in die sehr gut andere Elemente wie Natrium und Kupfer eingebaut werden können. Die Abscheidung der Pufferschicht 5 kann bei höheren Temperaturen erfolgen, insbesondere bei Temperaturen von Raumtemperatur bis etwa 200°C. Die nachfolgende transparente Frontelektrode 7 wird ebenfalls bevorzugt bei Temperaturen bis zu 200°C abgeschieden. Bei diesen Temperaturen können Natrium, Kupfer und Selen aus der Absorberschicht 4 oder der Frontelektrode 7 in die Pufferschicht 5 eindiffundieren. In diesem Fall können bei Vorbelegung mit einer Metall-Halogen-Verbindung neben dem Halogen auch diese Elemente an der Grenzfläche angereichert sein. Je nach Wahl der Metall-Halogen-Verbindung wird sich auch das begleitende Metall in dem ersten Schichtbereich 5.1 der Pufferschicht 5 anreichern. Aufgrund der hygroskopischen Eigenschaften der Ausgangsmaterialien ist eine Anreicherung von Wasser aus der Umgebungsluft ebenfalls denkbar.

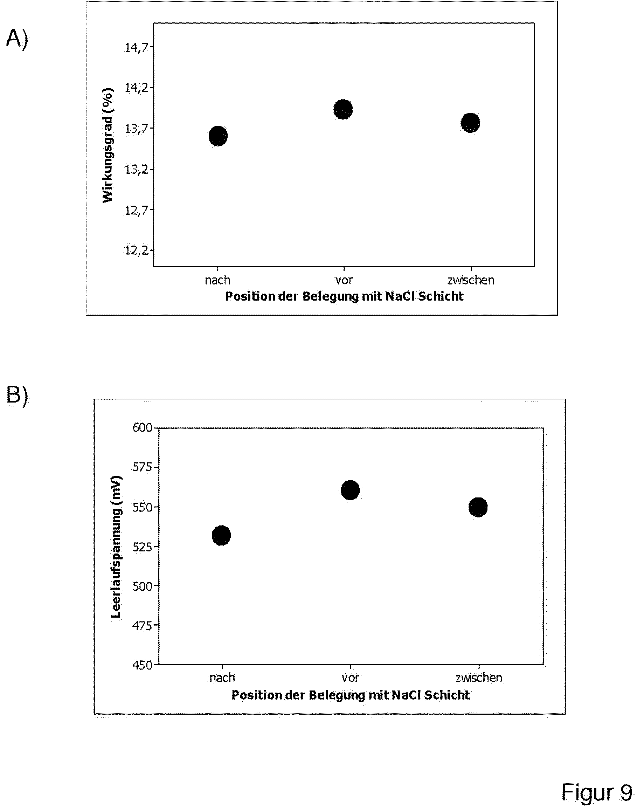

Figur 9 A zeigt den Wirkungsgrad und Figur 9 B die Leerlaufspannung in Abhängigkeit von der Verteilung einer NaCl-Anreicherung in der Pufferschicht 5. Verglichen werden Solarzellen 100 mit Schichtsystemen 1, bei denen nach der Abscheidung der Pufferschicht 5 ("nach"), vor der Abscheidung der Pufferschicht ("vor") und innerhalb der Pufferschicht 5 ("zwischen") Natriumchlorid aufgebracht wurde. Die Solarzelle 100 entspricht der Anordnung, wie sie unter Figur 1 beschrieben wurde. Das Schichtsystem 1 "vor", bei dem vor der Abscheidung der Pufferschicht Natriumchlorid abgeschieden wurde, zeigt den höchsten Wirkungsgrad von durchschnittlich 14 % und die höchste durchschnittliche Leerlaufspannung von 560 mV. Figur 9 A und Figur 9 B belegen die besondere Wirksamkeit einer Halogen-Anreicherung in einem ersten Schichtbereich 5.1 an der Grenzfläche zur Absorberschicht 4 durch eine Vorbelegung der Absorberschicht 4 mit Natriumchlord ("vor") im Gegensatz zu einer Positionierung in der Mitte der Pufferschicht 5 ("zwischen") oder einer Nachbelegung ("nach") an der Grenzfläche zur zweiten Pufferschicht 6.

Die wesentliche Idee für diese Erfindung ist den Stromgewinn durch einen Anteil an Zink, wie er in Figur 3 gezeigt wurde, mit einer Steigerung der Leerlaufspannung durch eine Halogen-Anreicherung der Pufferschicht 5 an der Grenzfläche zur Absorberschicht 4, wie es in Figur 9 B gezeigt wurde, zu kombinieren. Auf diese Weise konnten besonders vorteilhafte Schichtsysteme 1 erhalten werden.

Untersuchungen der Erfinder ergaben, dass auch eine Dotierung der gesamten Pufferschicht 5 mit Natrium und insbesondere mit Natriumchlorid die Kurzschlussstromstärke einer Solarzelle 100 erhöht. Dies lässt sich durch eine Aufweitung der Bandlücke in der Pufferschicht 5 durch die Natrium-Dotierung erklären. Da Natrium vergleichsweise mobil ist, ist bei der Zulegierung von Natrium zu einer In₂S₃-Pufferschicht nach dem Stand der Technik eine Ausdiffusion von Natrium aus der Pufferschicht in die Absorberschicht oder die Frontelektrode nicht auszuschließen. Die Erhöhung von Natrium in der Absorberschicht kann jedoch zu einer Zunahme der Absorberleitfähigkeit, zur Entstehung von Kurzschlüssen und zu einer Reduzierung der Verarmungszonenbreite führen. In der vorliegenden Erfindung wird die Aufweitung der Bandlücke durch die Zugabe von Zink in die Pufferschicht 5 erreicht und von dem positiven Effekt einer Halogen-Anreicherung in einer ersten Pufferschicht 5.1 an der Grenzfläche zur Absorberschicht 4 getrennt. Wie Untersuchungen der Erfinder ergaben, ist Zink dabei stabil in der Pufferschicht 5 gebunden. Auf diese Weise lassen sich besonders vorteilhafte Solarzellen mit besonders hohen Wirkungsgraden und besonders hoher Stabilität erzielen.

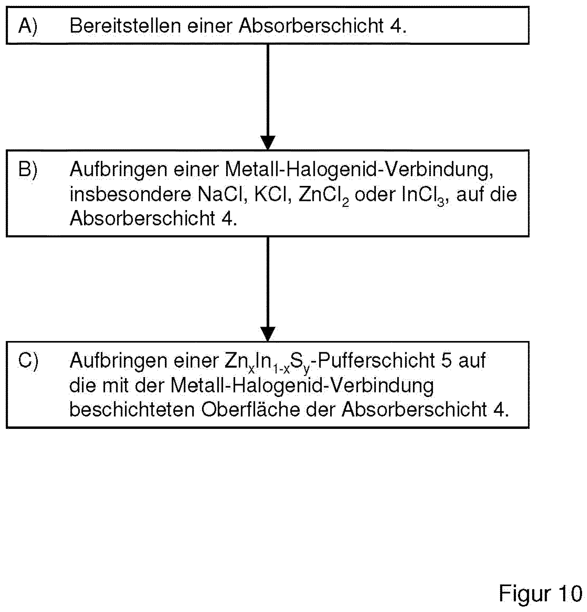

Figur 10 zeigt ein Flussdiagramm eines erfindungsgemäßen Verfahrens. In einem ersten Schritt wird eine Absorberschicht 4 beispielsweise aus einem Cu(In,Ga)(S,Se)₂-Halbleitermaterial bereitgestellt. In einem zweiten Schritt wird die Pufferschicht 5 aus Natrium und Chlor, beispielsweise aus Natriumchlorid, und Zinkindiumsulfid abgeschieden. Das Zinkindiumsulfid wird beispielsweise durch gleichzeitiges Abscheiden von Zinksulfid und Indiumsulfid abgeschieden. Das Verhältnis der einzelnen Komponenten in der Pufferschicht 5 wird beispielsweise durch eine Steuerung der Aufdampfrate geregelt, beispielsweise durch eine Blende oder eine Temperatursteuerung.

In weiteren Prozessschritten kann eine zweite Pufferschicht 6 und eine Frontelektrode 7 auf der Pufferschicht 5 abgeschieden werden. Des Weiteren kann eine Verschaltung und Kontaktierung der Schichtstruktur 1 zu einer Dünnschichtsolarzelle 100 oder einem Solarmodul erfolgen.

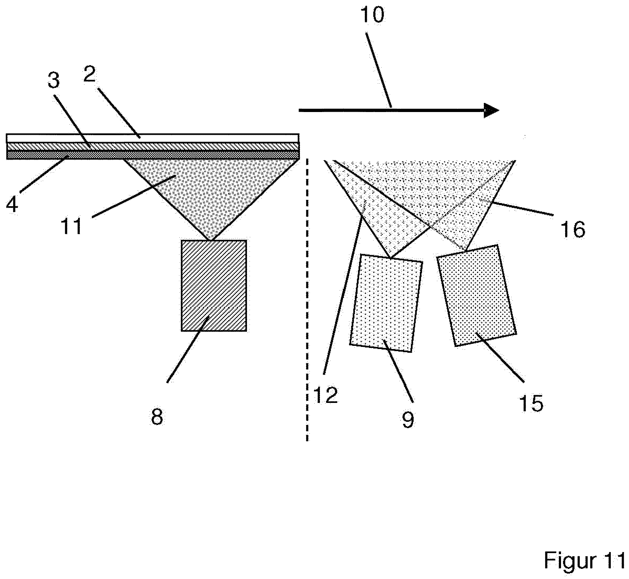

Figur 11 zeigt eine schematische Darstellung eines In-Line-Verfahrens zur Herstellung einer erfindungsgemäßen Pufferschicht 5. Das Substrat 2 mit Rückelektrode 3 und Absorberschicht 4 wird in einem In-Line-Verfahren an der Dampfkeule 11 einer halogenhaltigen Verdampferquelle und beispielsweise an einer Natriumchlorid-Quelle 8 vorbeigeführt. Die Transportrichtung ist durch einen Pfeil mit dem Bezugszeichen 10 angegeben.

Die abgeschiedene Menge an Natriumchlorid wird beispielsweise durch Öffnen und Schließen einer Blende so eingestellt, dass eine NaCl-Menge von mehr als 1 x 10¹³ Atomen/cm² und weniger als 1 x 10¹⁷ Atomen/cm² auf der Oberfläche abgeschieden wird.

Anschließend wird die mit Natriumchlorid vorbelegte Absorberschicht 4 an mindestens einer Indiumsulfid-Quelle 9 und einer Zinksulfid-Quelle 15 vorbeigeführt. Dies erfolgt bevorzugt ohne Vakuumunterbrechung. Durch Aufdampfraten, Transportgeschwindigkeiten und Anzahl der Halogenquellen 8, der Indiumsulfidquellen 9 und der Zinksulfidquellen 15 kann die Schichtdicke d der Pufferschicht 5, das Verhältnis x/(1-x) von Zink zu Indium und das Halogen-Anreicherungsprofil über die Pufferschicht 5 gesteuert werden.

Die Quelle für die Verdampfung der Metall-Halogen-Verbindung, von Indiumsulfid oder Zinksulfid ist beispielsweise eine Effusionszelle, ein Schiffchen oder Tiegel eines thermischen Verdampfers, einer Widerstandsheizung, eines Elektronenstrahlverdampfers oder eines Linearverdampfers.

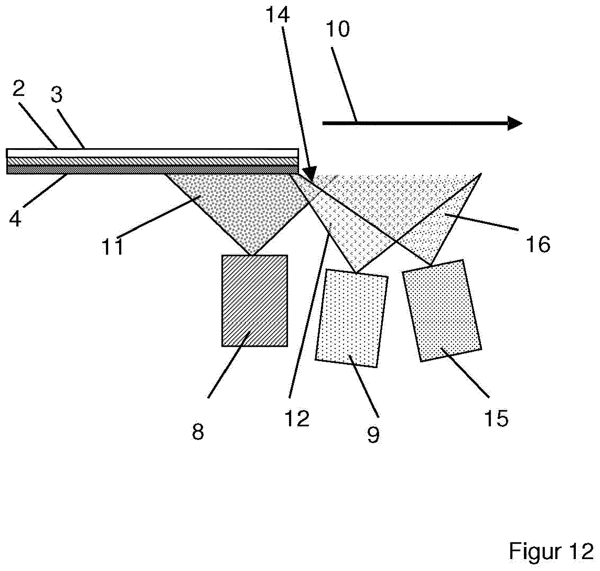

Figur 12 zeigt eine schematische Darstellung eines alternativen In-Line-Verfahrens zur Herstellung einer erfindungsgemäßen Pufferschicht 5. Die Indiumsulfid-Quelle 9 und die Zinksulfid-Quelle 15 sind dabei derart angeordnet, dass sich deren Dampfkeulen 12,16 nahezu vollständig überlappen. Die Natriumchlorid-Quelle 8 ist derart angeordnet, dass sich die Dampfkeule 11 der Natriumchlorid-Quellen 8 und die Dampfkeulen 12,16 der Indiumsulfid-Quelle 9 und der Zinksulfid-Quelle 16 in einem Überlappungsbereich 14 teilweise überlappen. Die Natriumchlorid-Quelle 8, die Indiumsulfid-Quelle 9 und die Zinksulfid-Quelle 9 sind beispielsweise Effusionszellen, aus denen Natriumchlorid beziehungsweise Indiumsulfid thermisch verdampft wird. Alternativ ist jede andere Form der Erzeugung von Dampfkeulen 11,12,16 zur Abscheidung der Pufferschicht 5 geeignet, sofern sich das Verhältnis der Stoffmengenanteile von Chlor, Zink, Indium und Schwefel steuern lässt.

Auf diese Weise lässt sich beispielsweise ein Gradient mit einer kontinuierlichen Abnahme der Halogen-Konzentration in der Pufferschicht 5 ausbilden. Wie Untersuchungen der Erfinder gezeigt haben, ist ein derartiger Gradient besonders vorteilhaft für die Eigenschaften der erfindungsgemäßen Solarzelle 100.

Das Einbringen von Chlor aus Natriumchlorid, Indiumchlorid oder Zinkchlorid in die Indiumsulfid-Pufferschicht 5 hat mehrere besondere Vorteile. Natriumchlorid ist nichttoxisch und kostengünstig und kann, wie bereits erwähnt, leicht über thermische Verfahren aufgebracht werden. Beim thermischen Verdampfen verdampft Natriumchlorid als NaCl-Molekül und dissoziiert nicht zu Natrium und Chlor. Dies hat den besonderen Vorteil, dass während des Verdampfens kein giftiges und korrosives Chlor entsteht.

Das Einbringen von Chlor aus Natriumchlorid bietet zusätzliche produktionstechnische Vorteile. Es muss nur ein Stoff aufgedampft werden, was den Prozess im Gegensatz zu möglichen Stoffmischungen wie NaCl/ZnS/In₂S₃ stark vereinfacht. So ist die Dampfdruckkurve von NaCl beispielsweise bekannt aus C.T. Ewing, K.H. Stern, "Equilibrium Vaporization Rates and Vapor Pressures of Solid and Liquid Sodium Chloride, Potassium Chloride, Potassium Bromide, Cesium Iodide, and Lithium Fluoride", J. Phys. Chem., 1974, 78, 20, 1998-2005, und ein thermischer Verdampfungsprozess kann leicht über die Temperatur gesteuert werden. Des Weiteren lässt sich eine Anordnung zur Verdampfung von Natriumchlorid leicht in bestehende thermische Indiumsulfid-Beschichtungsanlagen integrieren.

Des Weiteren lässt sich eine Halogenid-Anreicherung einfach kontrollieren und messen. So kann zur Prozesskontrolle während des Aufdampfens ein Schwingquartz zur direkten Messung der Rate verwendet werden. Eine optische Kontrolle der Natrium-Menge und damit der Chorid-Menge ist über Emissionsspektroskopie ebenfalls einsetzbar. Alternativ kann Natriumchlorid auf Silizium aufgedampft werden und diese durch Röntgensfluoreszenzanalyse (RFA), mit einem Ellipsometer oder einem Photospektrometer In-line oder nach dem Prozess untersucht werden. Das Einbringen von Chlor aus Indiumchlorid oder Zinkchlorid in die Zinkindiumsulfid-Pufferschicht 5 hat den Vorteil, dass Indium und Zink Bestandteile der Pufferschicht 5 sind und dadurch keine weiteren, die Funktion beeinträchtigenden Fremdmetalle in die Pufferschicht 5 gelangen.

Aus den vorstehenden Ausführungen ist klar geworden, dass durch die vorliegende Erfindung die Nachteile von bisher verwendeten CdS-Pufferschichten beziehungsweise den alternativen Pufferschichten bei Dünnschichtsolarzellen überwunden werden konnten, wobei der Wirkungsgrad und die Stabilität der damit erzeugten Solarzellen ebenfalls sehr gut oder besser ist. Gleichzeitig ist das Herstellungsverfahren kostengünstig, effektiv und umweltschonend. Dies war für den Fachmann unerwartet und überraschend.

### Bezugszeichen

- 1: Schichtsystem
- 2: Substrat
- 3: Rückelektrode
- 4: Absorberschicht
- 5: Pufferschicht
- 5.1: erster Schichtbereich
- 5.2: zweiter Schichtbereich
- 6: zweite Pufferschicht
- 7: Frontelektrode
- 8: Natriumchlorid-Quelle
- 9: Indiumsulfid-Quelle
- 10: Transportrichtung
- 11: Natriumchlorid-Dampfkeule
- 12: Indiumsulfid-Dampfkeule
- 14: Überlappungsbereich
- 15: Zinksulfid-Quelle
- 16: Zinksulfid-Dampfkeule
- 100: Dünnschichtsolarzelle, Solarzelle
- d: Schichtdicke der Pufferschicht 5
- d₁: Schichtdicke des ersten Schichtbereichs 5.1
- s: Schichttiefe
- A₁: Halogen-Stoffmengenanteil im ersten Schichtbereich 5.1
- A₂: Halogen-Stoffmengenanteil im zweiten Schichtbereich 5.2
- Analogen: Halogen-Stoffmengenanteil

## Patentansprüche

1. Schichtsystem (1) für Dünnschichtsolarzellen (100), umfassend:
- eine Absorberschicht (4), die einen Chalkogenidverbindungshalbleiter enthält und
- eine Pufferschicht (5), die auf der Absorberschicht (4) angeordnet ist und Halogen-angereichertes ZnₓIn₁₋ₓS_{y} mit 0,01 ≤ x ≤ 0,9 und 1 ≤ y ≤ 2 enthält,
wobei die Pufferschicht (5) aus einem an die Absorberschicht (4) angrenzenden ersten Schichtbereich (5.1) mit einem Halogen-Stoffmengenanteil A₁ und einem an den ersten Schichtbereich (5.1) angrenzenden zweiten Schichtbereich (5.2) mit einem Halogen-Stoffmengenanteil A₂ besteht und das Verhältnis A₁/A₂ ≥ 2 beträgt und die Schichtdicke (d₁) des ersten Schichtbereichs (5.1) ≤ 50 % der Schichtdicke (d) der Pufferschicht (5) beträgt.

2. Schichtsystem (1) nach Anspruch 1, wobei die Schichtdicke (d₁) des ersten Schichtbereichs (5.1) ≤ 30 % der Schichtdicke (d) der Pufferschicht (5) beträgt.

3. Schichtsystem (1) nach Anspruch 1 oder 2, wobei das Verhältnis A₁/A₂ von 2 bis 1000 beträgt.

4. Schichtsystem (1) nach einem der Ansprüche 1 bis 3, wobei die Menge des Halogens im ersten Schichtbereich (5.1) einer Flächenbelegung von 1•10¹³ Atomen/cm² bis 1̇•10¹⁷ Atomen/cm² beträgt.

5. Schichtsystem (1) nach einem der Ansprüche 1 bis 4, wobei y von x+(1-x)^{∗}1,3 bis x+(1-x)^{∗}1,5 beträgt.

6. Schichtsystem (1) nach einem der Ansprüche 1 bis 5, wobei der Halogen-Stoffmengenanteil in der Pufferschicht (5) einen Gradienten aufweist, der von der der Absorberschicht (4) zugewandten Oberfläche zum Inneren der Pufferschicht (5) abfällt.

7. Schichtsystem (1) nach einem der Ansprüche 1 bis 6, wobei die Schichtdicke (d) der Pufferschicht (5) von 5 nm bis 150 nm beträgt.

8. Schichtsystem (1) nach einem der Ansprüche 1 bis 7, wobei das Halogen Chlor, Brom oder Iod ist.

9. Schichtsystem (1) nach einem der Ansprüche 1 bis 8, wobei der Chalkogenidverbindungshalbleiter Cu(In,Ga,Al)(S,Se)₂ enthält.

10. Dünnschichtsolarzelle (100), umfassend:
- ein Substrat (2),
- eine Rückelektrode (3), die auf dem Substrat (2) angeordnet ist,
- ein Schichtsystem (1) nach einem der Ansprüche 1 bis 9, das auf der Rückelektrode (3) angeordnet ist und
- eine Frontelektrode (7), die auf dem Schichtsystem (1) angeordnet ist.

11. Verfahren zur Herstellung eines Schichtsystems (1) für Dünnschichtsolarzellen (100), wobei
a) eine Absorberschicht (4), die einen Chalkogenidverbindungshalbleiter enthält, bereitgestellt wird und
b) eine Pufferschicht (5), die Halogen-angereichertes ZnₓIn₁₋ₓS_{y} mit 0,01 ≤ x ≤ 0,9 und 1 ≤ y ≤ 2 enthält, auf der Absorberschicht (4) angeordnet wird, wobei die Pufferschicht (5) aus einem an die Absorberschicht (4) angrenzenden ersten Schichtbereich (5.1) mit einem Halogen-Stoffmengenanteil A₁ und einem an den ersten Schichtbereich (5.1) angrenzenden zweiten Schichtbereich (5.2) mit einem Halogen-Stoffmengenanteil A₂ besteht und das Verhältnis A₁/A₂ ≥ 2 beträgt und die Schichtdicke (d₁) des ersten Schichtbereichs (5.1) ≤ 50 % der Schichtdicke (d) der Pufferschicht (5) beträgt.

12. Verfahren nach Anspruch 11, wobei im Schritt b) eine Metall-Halogenid-Verbindung auf die Absorberschicht (4) aufgebracht wird und Zinkindiumsulfid auf die Metall-Halogenid-Verbindung aufgebracht wird.

13. Verfahren nach Anspruch 11, wobei im Schritt b) eine Metall-Halogenid-Verbindung und Zinkindiumsulfid auf die Absorberschicht (4) aufgebracht wird.

14. Verfahren nach Anspruch 13, wobei die Absorberschicht (4) an mindestens einer Dampfkeule der Metall-Halogenid-Verbindung (11) und mindestens einer Dampfkeule von Indiumsulfid (12) und Zinksulfid (16) vorbeigeführt wird.

15. Verfahren nach einem der Ansprüche 12 bis 14, wobei die Metall-Halogenid-Verbindung mit Chlor, Brom und/oder Iod als Halogen und Natrium oder Kalium, Aluminium, Gallium, Indium, Zink, Cadmium und/oder Quecksilber als Metall aufgebracht wird.

## Claims

1. Layer system (1) for thin-film solar cells (100), comprising:
- an absorber layer (4), which includes a chalcogenide compound semiconductor, and
- a buffer layer (5), which is arranged on the absorber layer (4) and includes halogen-enriched ZnₓIn₁₋ₓS_{y} with 0.01 ≤ x ≤ 0,9 and 1 ≤ y ≤ 2,
wherein the buffer layer (5) consists of a first layer region (5.1) adjoining the absorber layer (4) with a halogen mole fraction A₁ and a second layer region (5.2) adjoining the first layer region (5.1) with a halogen mole fraction A₂ and the ratio A₁/A₂ is ≥ 2 and the layer thickness (d₁) of the first layer region (5.1) is ≤ 50 % of the layer thickness (d) of the buffer layer (5).

2. Layer system (1) according to claim 1, wherein the layer thickness (d₁) of the first first layer region (5.1) is ≤ 30 % of the layer thickness (d) of the buffer layer (5).

3. Layer system (1) according to claim 1 or 2, wherein the ratio A₁/A₂ is from 2 to 1000.

4. Layer system (1) according to one of claims 1 through 3, wherein the amount of the halogen in the first layer region (5.1) amounts to an area concentration of 1•10¹³ atoms/cm² to 1•10¹⁷ atoms/cm².

5. Layer system (1) according to one of claims 1 through 4, wherein y is from x+(1-x)^{∗}1.3 to x+(1-x)^{∗}1.5.

6. Layer system (1) according to one of claims 1 through 5, wherein the halogen mole fraction in the buffer layer (5) has a gradient that decreases from the surface facing the absorber layer (4) to the interior of the buffer layer (5).

7. Layer system (1) according to one of claims 1 through 6, wherein the layer thickness (d) of the buffer layer (5) is from 5 nm to 150 nm.

8. Layer system (1) according to one of claims 1 through 7, wherein the halogen is chlorine, bromine, or iodine.

9. Layer system (1) according to one of claims 1 through 8, wherein the chalcogenide compound semiconductor includes Cu(In,Ga,Al)(S,Se)₂.

10. Thin-film solar cell (100), comprising:
- a substrate (2),
- a rear electrode (3) that is arranged on the substrate (2),
- a layer system (1) according to one of claims 1 through 9 that is arranged on the rear electrode (3), and
- a front electrode (7) that is arranged on the layer system (1).

11. Method for producing a layer system (1) for thin-film solar cells (100), wherein
a) an absorber layer (4) which includes a chalcogenide compound semiconductor is prepared, and
b) a buffer layer (5), which contains halogen-enriched ZnₓIn₁₋ₓS_{y} with 0.01 ≤ x ≤ 0.9 and 1 ≤ y ≤ 2 is arranged on the absorber layer (4),
wherein the buffer layer (5) consists of a first layer region (5.1) adjoining the absorber layer (4) with a halogen mole fraction A₁ and a second layer region (5.2) adjoining the first layer region (5.1) with a halogen mole fraction A₂ and the ratio A₁/A₂ is ≥ 2, and the layer thickness (d₁) of the first layer region (5.1) is ≤ 50 % of the layer thickness (d) of the buffer layer (5).

12. Method according to claim 11, wherein in the step b) a metal-halide compound is applied on the absorber layer (4) and zinc indium sulfide is applied on the metal-halide compound.

13. Method according to claim 11, wherein in the step b) a metal-halide compound and zinc indium sulfide are applied on the absorber layer (4).

14. Method according to claim 13, wherein the absorber layer (4) is conveyed past at least one steam beam of the metal-halide compound (11) and at least one steam beam of indium sulfide (12) and zinc sulfide (16).

15. Method according to one of claims 12 through 14, wherein the metal-halide compound with chlorine, bromine, and/or iodine as halogen and sodium or potassium, aluminum, gallium, indium, zinc, cadmium, and/or mercury as metal is applied.

## Revendications

1. Système de couches (1) pour cellules solaires à couche mince (100), comprenant :
- une couche absorbante (4) qui contient un semi-conducteur d'un composé de chalcogénure et
- une couche tampon (5) qui est disposée sur la couche absorbante (4) et qui contient du ZnₓIn₁₋ₓS_{y} enrichi en halogène avec 0,01 ≤ x ≤ 0,9 et 1 ≤ y ≤ 2, où la couche tampon (5) est constituée d'une première zone de couche (5.1) adjacente à la couche absorbante (4) avec une fraction molaire d'halogène A₁ et une deuxième zone de couche (5.2) adjacente à la première région de couche (5.1) avec une fraction molaire d'halogène A₂ et le rapport A₁/A₂ est ≥2 et l'épaisseur de couche (d₁) de la première région de couche (5.1) est < 50 % de l'épaisseur de couche (d) de la couche tampon (5).

2. Système de couches (1) selon la revendication 1, où l'épaisseur de couche (d₁) de la première région de couche (5.1) est < 30 % de l'épaisseur de couche (d) de la couche tampon (5).

3. Système de couches (1) selon la revendication 1 ou 2, où le rapport A₁/A₂ est de 2 à 1000.

4. Système de couches (1) selon l'une des revendications 1 à 3, où la quantité d'halogène dans la première région de couches (5.1) d'une couverture de surface de 1•10¹³ atomes/cm2 à 1•10¹⁷ atomes/cm2.

5. Système de couches (1) selon l'une quelconque des revendications 1 à 4, où y est compris entre x+(1-x)^{∗}1,3 et x+(1-x)^{∗}1,5.

6. Système de couches (1) selon l'une des revendications 1 à 5, où la fraction molaire d'halogène dans la couche tampon (5) présente un gradient qui diminue depuis la surface tournée vers la couche absorbante (4) vers l'intérieur de la couche tampon (5).

7. Système de couches (1) selon l'une des revendications 1 à 6, où l'épaisseur de couche (d) de la couche tampon (5) est de 5 nm à 150 nm.

8. Système de couches (1) selon l'une des revendications 1 à 7, où l'halogène est le chlore, le brome ou l'iode.

9. Système de 9e couche (1) selon l'une des revendications 1 à 8, où le semi-conducteur d'un composé de chalcogénure contient du Cu(In,Ga,Al)(S,Se)₂.

10. Cellule solaire à couche mince (100) comprenant :
- un substrat (2),
- une électrode arrière (3) qui est disposée sur le substrat (2),
- un système de couches (1) selon l'une des revendications 1 à 9, qui est disposé sur l'électrode arrière (3) et
- une électrode frontale (7) qui est disposée sur le système de couches (1).

11. Procédé de fabrication d'un système de couches (1) pour cellules solaires à couche mince (100), où
a) une couche absorbante (4) contenant un le semi-conducteur d'un composé de chalcogénure est fournie ;
et
b) une couche tampon (5) qui contient du ZnₓIn₁₋ₓS_{y} enrichi en halogène avec 0,01 ≤ x ≤ 0,9 et 1 ≤ y ≤ 2 est disposée sur la couche absorbante (4), où la couche tampon (5) est constituée d'une première zone de couche (5.1) adjacente à la couche absorbante (4) avec une fraction molaire d'halogène A₁ et une deuxième zone de couche (5.2) adjacente à la première région de couche (5.1) avec une fraction molaire d'halogène A₂ et le rapport A₁/A₂ est ≥2 et l'épaisseur de couche (d₁) de la première région de couche (5.1) est < 50 % de l'épaisseur de couche (d) de la couche tampon (5).

12. Procédé selon la revendication 11, où, dans l'étape b), un composé d'halogénure métallique est appliqué sur la couche absorbante (4) et du sulfure de zinc et d'indium est appliqué sur le composé d'halogénure métallique.

13. Procédé selon la revendication 11, où, à l'étape b), un composé d'halogénure métallique et de sulfure de zinc et d'indium est appliqué sur la couche absorbante (4).

14. Procédé selon la revendication 13, où la couche absorbante (4) passe à au moins un lobe de vapeur du composé d'halogénure métallique (11) et au moins un lobe de vapeur de sulfure d'indium (12) et de sulfure de zinc (16).

15. Procédé selon l'une des revendications 12 à 14, où le composé d'halogénure métallique est appliqué avec du chlore, du brome et/ou de l'iode comme halogène et du sodium ou du potassium, de l'aluminium, du gallium, de l'indium, du zinc, du cadmium et/ou du mercure comme métal.
